# EUROPÄISCHE PATENTANMELDUNG

(11) **EP 4 647 815 A1**
(43) Veröffentlichungstag der Anmeldung: **12.11.2025**
(21) Anmeldenummer: 25165057.8
(22) Anmeldetag: 20.03.2025
(51) Int. Cl.: G02B 1/12, G02B 5/08, G03F 7/20, G21K 1/06, H01J 37/317, G02B 7/18

(54) **VERFAHREN ZUM HERSTELLEN EINES SPIEGELS**

(30) Priorität: 08.05.2024 DE 102024204314
(71) Anmelder: Carl Zeiss SMT GmbH, 73447 Oberkochen (DE)
(72) Erfinder: LINK, Stefan, 73447 Oberkochen (DE); NOAH, Martin, 73447 Oberkochen (DE)
(74) Vertreter: Kohler Schmid Möbus Patentanwälte

(57) **Zusammenfassung**

Die Erfindung betrifft ein Verfahren zum Herstellen eines Spiegels (Mi) für eine Anlage der Halbleiterlithographie, insbesondere für ein EUV-Lithographiesystem, umfassend: Aufbringen einer reflektierenden Beschichtung (26) auf eine Oberfläche (25a) eines Substrats (25) des Spiegels (Mi), Lokales Kompaktieren des Substrats (25), bevorzugt durch Elektronenstrahlbearbeiten, insbesondere mit nachfolgendem Tempern, insbesondere homogenem Tempern, sowie lokales Kompaktieren der reflektierenden Beschichtung (26) durch lokales, bevorzugt strahlungsinduziertes Tempern des Spiegels (Mi). Bei der Herstellung des Spiegels (Mi) werden das lokale Kompaktieren des Substrats (25) und das lokale Kompaktieren der Beschichtung (26) gemeinsam optimiert, wobei folgende Einflussfaktoren berücksichtigt werden: eine lokale Oberflächenform (P_{A}, P_{B}) bei der Herstellung des Spiegels (Mi), eine Veränderung der lokalen Oberflächenform (P_{A}, P_{B}) durch Dekompaktieren des Substrats (25) über die Lebensdauer des Spiegels (Mi), eine lokale Reflektivität (R_{A}, R_{B}) des Spiegels (Mi), eine Veränderung der lokalen Reflektivität (R_{A}, R_{B}) durch Kompaktierung der reflektierenden Beschichtung (26) über die Lebensdauer des Spiegels (Mi), sowie eine zu erwartende Temperaturverteilung an der Oberfläche (25a) des Substrats (25) beim Betrieb des Spiegels (Mi) in der Anlage der Halbleiterlithographie.

## Beschreibung

Die Erfindung betrifft ein Verfahren zum Herstellen eines Spiegels für eine Anlage der Halbleiterlithographie, insbesondere für ein EUV-Lithographiesystem, umfassend: Aufbringen einer reflektierenden Beschichtung auf eine Oberfläche eines Substrats des Spiegels, lokales Kompaktieren des Substrats, bevorzugt durch Elektronenstrahlbearbeiten, insbesondere mit nachfolgendem Tempern, insbesondere mit homogenem Tempern, sowie lokales Kompaktieren der reflektierenden Beschichtung durch lokales, bevorzugt strahlungsinduziertes Tempern des Spiegels. Beim lokalen Kompaktieren der reflektierenden Beschichtung erfolgt auch ein lokales Dekompaktieren der lokal kompaktierten Bereiche des Substrats (s.u.).

Bei der Anlage der Halbleiterlithographie kann es sich um eine Lithographieanlage, insbesondere um eine EUV-Lithographieanlage, zur Belichtung eines Wafers handeln. Es kann sich aber auch um eine andere Anlage handeln, beispielsweise um ein Inspektionssystem, z.B. zur Inspektion von in der Halbleiterlithographie verwendeten Masken, Wafern oder dergleichen. Der Spiegel kann insbesondere in einem Projektionssystem einer Lithographieanlage angeordnet sein, um ein Muster auf einer Maske auf den Wafer abzubilden.

Spiegel für Anlagen der Halbleitertechnologie, insbesondere für EUV-Lithographieanlagen, werden an einer Oberfläche ihres Substrats mit einer reflektierenden Beschichtung versehen. Die reflektierende Beschichtung kann ein Schichtsystem mit einer Mehrzahl von Schichten aufweisen. Insbesondere kann das Schichtsystem als Interferenzschichtsystem mit alternierenden Schichten mit hohem und mit niedrigem Brechungsindex ausgebildet sein. Es ist das Ziel der Herstellung eines solchen Spiegels, dass sowohl die Oberflächenform (Passe) zur Vermeidung von Wellenfrontfehlern und Streulicht als auch die Energetik, d.h. die Reflektivität für die verwendete EUV-Strahlung unter den vorkommenden Reflexionswinkeln, die Spezifikation erfüllen.

Es ist bekannt, direkt vor dem Aufbringen der reflektierenden Beschichtung die Passe, d.h. die Oberflächenform, des Spiegels durch Ionenstrahlbearbeiten einzustellen. Nach dem Aufbringen der Beschichtung erfüllt die Passe jedoch aufgrund der schwierig zu kontrollierenden Beschichtungsprozesse in der Regel nicht mehr die Spezifikation.

Die Passe des Spiegels kann nach dem Aufbringen der Beschichtung mit Hilfe eines in der WO2020011788A1 beschriebenen Verfahrens eingestellt bzw. korrigiert werden. Das dort beschriebene Verfahren umfasst ein Vermessen der Substratoberfläche, das Bestrahlen des Substrats mit Hilfe von Elektronen sowie das Tempern des Substrats. Durch die lokale Bestrahlung mit den Elektronen wird das Substrat lokal kompaktiert, um eine Soll-Oberflächenform zu erzeugen. Der abschließende Temperschritt führt zu einem teilweisen Rückgang der vorher eingebrachten Kompaktierung des Substratmaterials, d.h. zu einer Dekompaktierung. Eine solche Dekompaktierung tritt auch bei der Nutzung des Substrats in einer EUV-Lithographieanlage über die Zeit auf und kann zu einer nicht vernachlässigbaren Veränderung der Oberflächenform der Substratoberfläche führen. Das Tempern soll den Prozess der Dekompaktierung beschleunigen und die über die Lebensdauer des Substrats verbleibende Veränderung durch die Dekompaktierung auf einen vernachlässigbaren Wert reduzieren.

Durch die Temperung soll hierbei eine homogene Voralterung des Substrats hergestellt werden, d.h. während eines Temper-Zyklus werden jeweils als SollWerte einheitliche Temperaturen über die Oberfläche des Substrats hinweg vorgegeben. Neben der teilweisen Dekompaktierung der durch die lokale Bestrahlung hervorgerufenen Kompaktierung hat die Temperung jedoch noch einen weiteren Nebeneffekt zur Folge, nämlich eine Kompaktierung der reflektierenden Beschichtung: Beim Tempern verändert sich die Dicke der Einzelschichten des Schichtsystems der reflektierenden Beschichtung, was die reflektierende Beschichtung als Ganzes verstimmt und deren Reflexionsverhalten beeinflusst. Es ist daher in der Regel erforderlich, den Effekt der Schichtkompaktierung beim lokalen Kompaktieren des Substrats und der anschließenden Temperung zu berücksichtigen, damit sichergestellt ist, dass die Passe des Spiegels die Spezifikation erfüllt. Es ist möglich, diesen Effekt schon beim Aufbringen der Beschichtung auf das Substrat zu berücksichtigen, damit auch die Energetik/Reflektivität des Spiegels die Spezifikation erfüllt.

In der DE 10 2021 213 679 A1 wird vorgeschlagen, zum Erzeugen einer lokalen Dickenänderung einer reflektierenden Beschichtung einen lokalen Energieeintrag in die reflektierende Beschichtung einzubringen, der ein Kompaktieren oder Expandieren der Beschichtung bewirkt, um eine lokale Soll-Dicke der Beschichtung zu erzeugen, die einer lokalen Soll-Reflektivität des Spiegels entspricht. Der lokale Energieeintrag kann z.B. durch laserinduziertes Tempern erfolgen. Die Oberflächenform des Substrats bzw. des Spiegels kann durch das Einbringen eines lokalen Energieeintrags in das Substrat verändert werden. Eine beim Verändern der Oberflächenform des Substrats zu erwartende zusätzliche lokale Dickenänderung der Beschichtung kann bestimmt und beim Erzeugen der lokalen Dickenänderung kompensiert werden.

Bei der Herstellung von Spiegeln mit Hilfe des weiter oben beschriebenen Gesamtprozesses existiert zumindest bezüglich der folgenden Punkte ein Optimierungspotential:
- Die unterschiedlichen Prozesse (Beschichten, lokales Kompaktieren des Substrats mittels Elektronenstrahl mit anschließendem Tempern, lokales laserinduziertes Tempern) können unabhängig voneinander optimiert werden.
- Der Entwicklungsaufwand bei der Entwicklung der Beschichtungsprozesse ist hoch, um die erforderliche Genauigkeit bezüglich der Energetik bzw. von deren Vorhalt zu erreichen.
- Die Korrektur von Fehlern bezüglich der Energetik ist nach dem Beschichten durchführbar
- Für den Beschichtungsprozess müssen geeignete Ortswellenlängen definiert und gezielt auf die Spiegel beschichtet werden.
- Das Lifetime-Verhalten der gegensätzlichen Effekte der Dekompaktierung der lokalen Kompaktierung des Substrats und der Kompaktierung der reflektierenden Beschichtung während der Nutzung in Anlagen der Halbleiterlithographie kann zum Vorteil genutzt werden. Dies birgt Potential zur Verbesserung des Fertigungsprozesses.

### Aufgabe der Erfindung

Aufgabe der Erfindung ist es, ein Verfahren zum Herstellen eines Spiegels zu optimieren.

### Gegenstand der Erfindung

Diese Aufgabe wird gelöst durch ein Verfahren der eingangs genannten Art, bei dem das lokale Kompaktieren des Substrats und das lokale Kompaktieren der reflektierenden Beschichtung bei der Herstellung des Spiegels gemeinsam optimiert werden, wobei folgende Einflussfaktoren berücksichtigt werden: eine lokale Oberflächenform bei der Herstellung des Spiegels, eine Veränderung der lokalen Oberflächenform durch Dekompaktierung des Substrats über die Lebensdauer des Spiegels, eine lokale Reflektivität des Spiegels, eine Veränderung der lokalen Reflektivität durch Kompaktierung der reflektierenden Beschichtung über die Lebensdauer des Spiegels, sowie eine zu erwartende Temperaturverteilung an der Oberfläche des Substrats beim Betrieb des Spiegels in der Anlage der Halbleiterlithographie.

Die lokale Oberflächenform, die Veränderung der lokalen Oberflächenform, die lokale Reflektivität sowie die Veränderung der lokalen Reflektivität werden typischerweise bis zu Ortswellenlängen in der Größenordnung von Zentimetern betrachtet bzw. berücksichtigt.

Bei dem erfindungsgemäßen Verfahren werden zusätzliche Freiheitsgrade in der Optimierung der Prozesse des lokalen Kompaktierens des Substrats und des lokalen Kompaktierens der reflektierenden Beschichtung zugelassen, indem bestimmte Interaktionen zwischen den Prozessen im Rezept-Optimierungs-Formalismus ermöglicht werden, um ein Optimum für den Gesamtprozess zu finden. Bei dem Optimum bzw. bei der zu optimierenden Größe kann es sich beispielsweise um das Minimum an Gesamt-Entwicklungsaufwänden handeln, um ein Maximum der Performance des Spiegels, um minimale Bearbeitungszeiten oder um möglichst schnelle Gesamt-Durchlaufzeiten. Eine Interaktion zwischen den beiden Prozessen kann eingeführt werden, indem mit Hilfe des oben beschriebenen Verfahrens die Möglichkeit bereitgestellt wird, Fehler in der Beschichtung zu korrigieren, aber auch die Eigenschaften der Beschichtung lokal gezielt zu verändern.

Das optimale hybride Rezept, d.h. die Soll-Vorgaben der beiden Prozesse, sowie ggf. zusätzlich die Soll-Vorgabe für die reflektierende Beschichtung in Bezug auf die fünf weiter oben genannten Einflussfaktoren zu finden, ist ein Problem, das mit Hilfe eines geeigneten Optimierungsalgorithmus zu lösen ist. Hierbei ist zu erwähnen, dass es sich bei den physikalischen Gesetzmäßigkeiten hinter der Dekompaktierung des Substrats und der damit einhergehenden Veränderung der lokalen Oberflächenform sowie der Kompaktierung der reflektierenden Beschichtung und der damit einhergehenden Veränderung der lokalen Reflektivität über die Lebensdauer des Spiegels um abklingende Funktionen mit den Parametern Temperatur und Zeit handelt. Daher kann schon eine geringe Optimierung des Rezepts bzw. der Soll-Vorgaben dazu führen, dass ein großer Teil der Bearbeitungszeiten eingespart werden kann, was einer Optimierung der Durchlaufzeit bei der Herstellung der Spiegel entspricht.

### Gängige relative Kompaktierungswerte können relativen

Schichtdickenvariationen bei der Beschichtung der einzelnen Spiegel entsprechen. Daher können prinzipiell Schichtdickenvariationen mit wenigen Nanometern an absoluter Variation erzeugt werden. Weiterhin bietet eine lokale Kompaktierung des Substrats die Möglichkeit, Passevariationen von einigen Nanometern auch in einem Ortswellenlängenbereich von mehreren Zentimetern zu erzeugen. Die lokale Kompaktierung der reflektierenden Beschichtung und die lokale Dekompaktierung des Substrats liegen entsprechend in derselben Größenordnung.

Die Schichtkompaktierungseffekte beim lokalen Tempern bieten somit ein Prozessfenster, bei dem die Spezifikationen an die Genauigkeit beim Aufbringen der Beschichtung signifikant angepasst werden können, was den Entwicklungsaufwand beim Aufbringen der Beschichtung des Substrats reduziert. Gleichzeitig kann dies auf sehr kurzen Ortswellenlängen erfolgen. Beispielsweise kann eine gezielte lokale Kompaktierung der reflektierenden Beschichtung erfolgen, sodass z.B. eine Strukturierung der Beschichtung erzeugt wird, oder die Eigenschaften der Beschichtung an neuralgischen Stellen auf den Spiegeln gezielt verändert werden. Dies ermöglicht flexible Fertigungswege für das Design von Optiken bzw. von Spiegeln für die EUV-Lithographie.

Die Kombination der lokalen Temperung mit der lokalen Kompaktierung des Substrats, ggf. mit nachfolgender insbesondere homogener Temperung, bietet hierbei ein ausreichendes Prozessfenster, um auch die Passe des Spiegels schlussendlich in Spezifikation bringen zu können. Der Energieeintrag bei der lokalen Temperung kann einen ortsabhängig variierenden Anteil und einem homogenen Anteil umfassen. Bei der Optimierung der Herstellung des Spiegels kann auch berücksichtigt werden, dass das lokale Tempern eine lokale Dekompaktierung des Substrats bewirkt.

Bei einer Variante des Verfahrens werden beim Herstellen des Spiegels die lokale Oberflächenform des Spiegels und die lokale Reflektivität des Spiegels gemessen. Für die Realisierung des weiter oben beschriebenen hybriden kombinierten Bearbeitungsrezepts ist es vorteilhaft, für jeden bearbeiteten Spiegel individuell die lokale Oberflächenform und die lokale Reflektivität zu messen. Diese beiden Messungen liefern die volle Information über die optischen Eigenschaften des Spiegels, die zum Erstellen des hybriden Bearbeitungsprozesses erforderlich sind, nämlich die lokale Oberflächenform bzw. Passe und die Schichtdicke der reflektierenden Beschichtung. Das hier beschriebene Verfahren, bei dem die lokale Oberflächenform und die lokale Reflektivität für den bearbeiteten Spiegel - nach der Beschichtung - gemessen werden, ermöglicht das Auffinden eines Bearbeitungsrezepts für die lokale Elektronenstrahlbearbeitung und die lokale Temperung individuell für jeden einzelnen Spiegel, bei dem sowohl die Passe als auch die Energetik optimiert werden.

Bei einer weiteren Variante wird beim lokalen Tempern des Spiegels eine ortsabhängige Temperaturverteilung an der Oberfläche des Substrats gemessen. Die lokale, insbesondere strahlungsinduzierte, beispielsweise laserinduzierte Temperung des Spiegels lässt prinzipiell die lokale Kontrolle über die Temperatur während der Temperung zu. Hierbei kann die Oberfläche des Substrats gezielt lokal geheizt werden, z.B. mittels einer örtlich variabel eingebrachten Heizleistung in Verbindung mit einer Gegenkühlung. Die sich einstellende Temperaturverteilung auf der Oberfläche des Substrats kann prinzipiell per Rezept, d.h. durch eine Soll-Vorgabe, vorgegeben werden. Die Temperatur selbst wird geregelt durch eine Anordnung von Wärmebildkameras, welche die Möglichkeit bieten, die Temperatur an der gesamten Oberfläche ortsaufgelöst zu bestimmen, um die Ist-Temperatur an die Soll-Temperatur anzupassen. Die lokale laserinduzierte Temperung ermöglicht daher eine vorteilhafte Prozesskontrolle. Oberflächenmerkmale wie Täler oder Hügel in der Passe bzw. der Oberflächenform von beschichteten Spiegeln können mit einer Präzision von z.B. mehreren 10 pm in der Höhe und mindestens im ZentimeterBereich in der Ortswellenlänge erzeugt werden. Die Möglichkeit, bei der lokalen Temperung eine inhomogene Temperaturverteilung einzustellen, ergibt sich aus der geringen Wärmeleitfähigkeit des Substrats, bei dem es sich typischerweise um ein Substrat aus Glas, z.B. aus titandotiertem Quarzglas, oder um eine Glaskeramik handelt.

Bei einer weiteren Variante erfolgt beim gemeinsamen Optimieren an Positionen an der Oberfläche des Substrats, an denen das Substrat stärker lokal kompaktiert wird, das lokale Tempern des Substrats mit einer höheren Temperatur als an Positionen an der Oberfläche des Substrats, an denen das Substrat weniger stark kompaktiert wird. Wie weiter oben beschrieben wurde, führt die lokale Kompaktierung des Substrats im Betrieb des Spiegels in der Anlage für die Halbleiterlithographie zu einer lokalen Dekompaktierung des Substrats, die umso größer ist, je stärker das Substrat lokal kompaktiert wurde. Durch das lokale Tempern bei einer höheren Temperatur erfolgt eine stärkere lokale Dekompaktierung des Substrats, welche die Veränderung der lokalen Oberflächenform durch Dekompaktierung über die Lebensdauer des Spiegels reduziert.

Bei einer weiteren Variante erfolgt beim gemeinsamen Optimieren an Positionen an der Oberfläche des Substrats, an denen die reflektierende Beschichtung lokal stärker kompaktiert wird, das lokale Tempern mit einer höheren Temperatur als an Positionen an der Oberfläche des Substrats, an denen die reflektierende Beschichtung lokal weniger stark kompaktiert wird.

Mit einer erhöhten Temperatur lokal getempert wird somit an Positionen, an denen die reflektierende Beschichtung lokal stärker kompaktiert wird und an denen das Substrat lokal stärker kompaktiert wird. Dies hat den günstigen Nebeneffekt, dass an diesen Positionen eine Korrelation zwischen der lokalen Kompaktierung des Substrats, der lokalen Kompaktierung der Beschichtung und dem lokalen Fehlerbild in der Beschichtung hergestellt wird, bei dem die Beschichtung im Betrieb des Spiegels in der Anlage für die Halbleiterlithographie über die Lebensdauer des Spiegels weniger stark kompaktiert wird und gleichzeitig das Substrat weniger stark dekompaktiert wird als dies an Positionen der Fall ist, die mit einer geringeren lokalen Temperatur getempert werden. Effektiv können auf diese Weise Veränderungen in der Passe des Spiegels, die zu Wellenfrontfehlern und Streulicht führen, über die Lebensdauer des Spiegels in dem EUV-Lithographiesystem verringert werden, was einer Optimierung der Performance des Spiegels entspricht.

Bei einer weiteren Variante wird die zu erwartende Temperaturverteilung an der Oberfläche des Substrats beim Betrieb des Spiegels in der Anlage der Halbleiterlithographie bei der Optimierung berücksichtigt, indem das lokale Tempern an Positionen der Oberfläche des Substrats, an denen beim Betrieb des Spiegels eine höhere Temperatur zu erwarten ist, mit einer höheren Temperatur erfolgt als an Positionen, an denen beim Betrieb des Spiegels eine geringere Temperatur zu erwarten ist. Die zu erwartende Temperaturverteilung an der Oberfläche des Substrats bzw. auf dem Spiegel bei der Nutzung des Spiegels in einer Anlage der Halbleiterlithographie, insbesondere in einem EUV-Lithographiesystem, hängt von dem durch die Bestrahlung mit der Nutzstrahlung erzeugten lokalen Wärmeeintrag und vom Wärmeeintrag ab, der ggf. durch Heizstrahlung erzeugt wird, die unter Verwendung von Heizköpfen auf die Oberfläche des Spiegels eingestrahlt wird. An Positionen mit einer höheren zu erwartenden lokalen Temperatur im Betrieb des Spiegels ist eine stärkere Voralterung durch eine höhere lokale Temperatur beim lokalen Tempern nötig, um die Veränderung der lokalen Oberflächenform über die Lebensdauer des Spiegels zu reduzieren.

Bei einer weiteren Variante des Verfahrens werden das lokale Kompaktieren des Substrats und das lokale Kompaktieren der reflektierenden Beschichtung bei der Herstellung des Spiegels unter Zuhilfenahme einer Methode des maschinellen Lernens gemeinsam optimiert.

Bei dem Verfahren werden insbesondere berücksichtigt: Produktionsdaten, wie beispielsweise Bearbeitungszeiten, erzielbare Genauigkeiten (insbesondere in Bezug auf die Beschichtung), Lebensdauerveränderungen der Spiegel im Betrieb der EUV-Anlage, Temperaturverteilungen auf der Spiegeloberfläche im Betrieb der EUV-Anlage, sowie Lebensdauerveränderungen der Spiegel ohne Einfluss von EUV-Strahlung.

Das Verfahren kann insbesondere mehrfach hintereinander oder iterativ ausgeführt werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: schematisch im Meridionalschnitt eine Projektionsbelichtungsanlage für die EUV-Projektionslithografie,
- Fig. 2a-c: schematische Darstellungen von drei Schritten bei der Herstellung eines Spiegels der Projektionsbelichtungsanlage von Fig. 1,
- Fig. 3a-d: schematische Darstellungen der Variation von verschiedenen lokalen Größen an einer Oberfläche des Spiegels, sowie
- Fig. 4a,b: schematische Darstellungen analog zu Fig. 2a-c unmittelbar nach der Herstellung des Spiegels und am Ende der Lebensdauer des Spiegels.

In der folgenden Beschreibung der Zeichnungen werden für gleiche bzw. funktionsgleiche Bauteile identische Bezugszeichen verwendet.

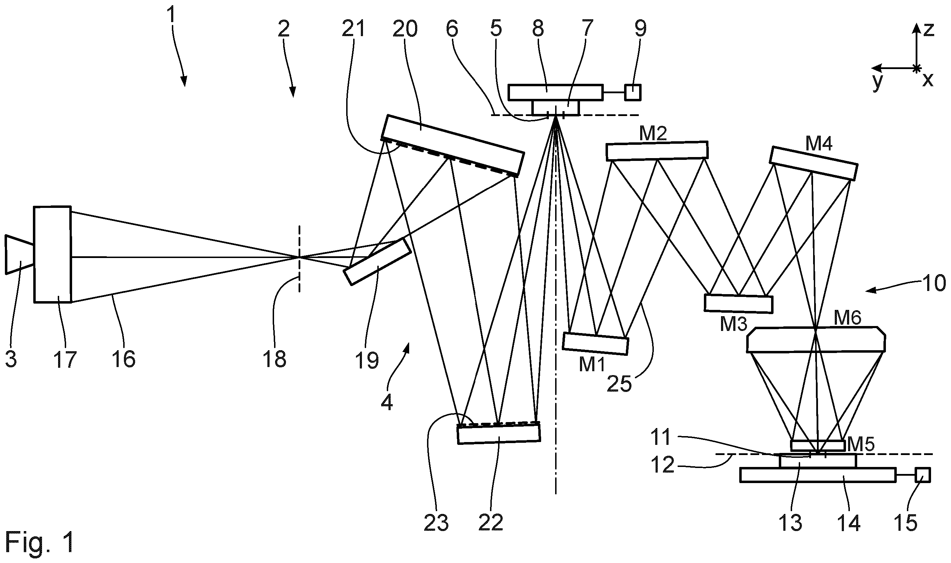

Im Folgenden werden unter Bezugnahme auf Fig. 1 exemplarisch die wesentlichen Bestandteile einer optischen Anordnung für die EUV-Lithographie in Form einer Projektionsbelichtungsanlage 1 für die Mikrolithographie beschrieben. Die Beschreibung des grundsätzlichen Aufbaus der Projektionsbelichtungsanlage 1 sowie von deren Bestandteilen ist hierbei nicht einschränkend zu verstehen.

Eine Ausführung eines Beleuchtungssystem 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In Fig. 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst ein Projektionssystem 10. Das Projektionssystem 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektorspiegel 17 gebündelt. Bei dem Kollektorspiegel 17 kann es sich um einen Kollektorspiegel mit einer oder mit mehreren ellipsoidalen und/oder hyperboloiden Reflexionsflächen handeln. Die mindestens eine Reflexionsfläche des Kollektorspiegels 17 kann im streifenden Einfall (Grazing Incidence, GI), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektorspiegel 17 kann einerseits zur Optimierung seiner Reflektivität für die Nutzstrahlung und andererseits zur Unterdrückung von Falschlicht strukturiert und/oder beschichtet sein.

Nach dem Kollektorspiegel 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektorspiegel 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt. Im Strahlengang der Beleuchtungsoptik 4 ist dem ersten Facettenspiegel 20 nachgeordnet ein zweiter Facettenspiegel 22. Der zweite Facettenspiegel 22 umfasst eine Mehrzahl von zweiten Facetten 23.

Die Beleuchtungsoptik 4 bildet somit ein doppelt facettiertes System. Dieses grundlegende Prinzip wird auch als Wabenkondensor (Fly's Eye Integrator) bezeichnet. Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Das Projektionssystem 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst das Projektionssystem 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei dem Projektionssystem 10 handelt es sich um eine doppelt obskurierte Optik. Die Projektionsoptik 10 hat eine bildseitige numerische Apertur, die größer ist als 0,4 oder 0,5 und die auch größer sein kann als 0,6 und die beispielsweise 0,7 oder 0,75 betragen kann.

Die Spiegel Mi können, genauso wie die Spiegel der Beleuchtungsoptik 4, eine hoch reflektierende Beschichtung für die Beleuchtungsstrahlung 16 aufweisen.

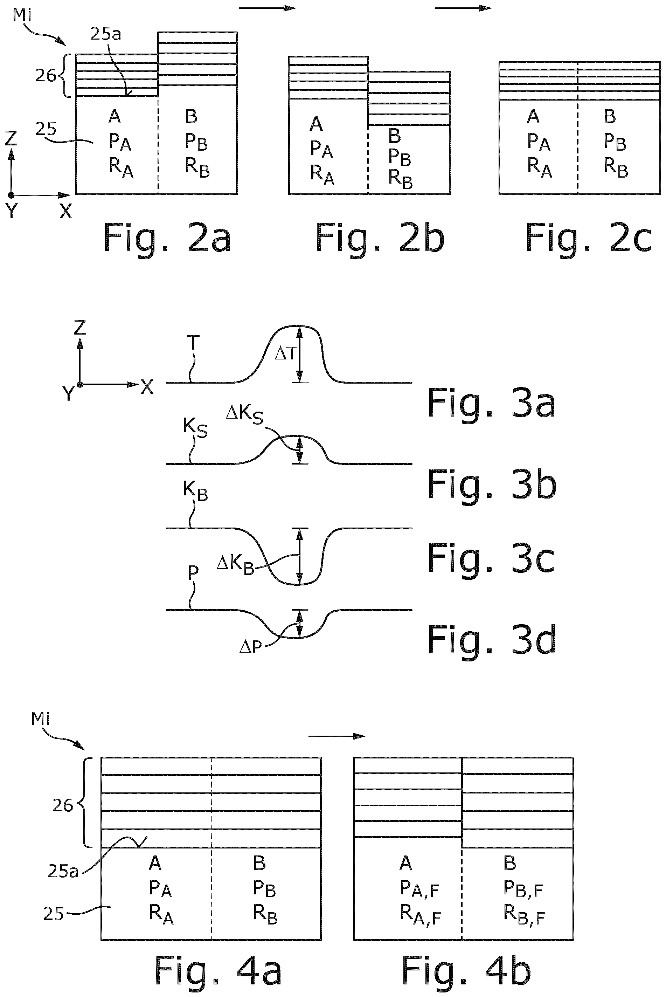

Fig. 2a-c zeigen drei Schritte bei der Herstellung eines Spiegels Mi des Projektionssystems 10 von Fig. 1. Fig. 2a zeigt den Spiegel Mi nach dem Aufbringen einer reflektierenden Beschichtung 26 auf eine Oberfläche 25a eines Spiegel-Substrats 25. Nach dem Aufbringen der reflektierenden Beschichtung 26 weicht an einer Position B der Oberfläche 25a des Substrats 25 eine Oberflächenform P_{B} des Substrats 25 in Form einer Erhöhung von einer Soll-Oberflächenform ab. An einer Position A der Oberfläche 25a des Substrats 25 stimmt die Oberflächenform P_{A}, hingegen mit der Soll-Oberflächenform überein.

Zudem sind die Einzelschichten der reflektierenden Beschichtung 26 an der Position B zu dick und somit ist auch die reflektierende Beschichtung 26 an der Position B als Ganzes gegenüber der reflektierenden Beschichtung 26 an der Position A zu dick. An der Position A weist die reflektierende Beschichtung 26 hingegen ihre Soll-Dicke auf. Die Reflektivität R_{B} an der Position B stimmt somit nicht mit der Soll-Reflektivität des Spiegels Mi überein, während die Reflektivität R_{A}, an der Position A der Soll-Reflektivität des Spiegels Mi entspricht.

An der Position B wird daher in einem auf das Aufbringen der reflektierenden Beschichtung 26 folgenden Schritt, der in Fig. 2b dargestellt ist, die Oberfläche 25a des Substrats 25 lokal mit einem nicht bildlich dargestellten Elektronenstrahl bestrahlt, der zu einer Kompaktierung des Substrats 25 an der Position B führt. An der Position B wird daher bei der Bestrahlung mit dem Elektronenstrahl eine höhere Strahlendosis eingebracht als an Position A, an der im gezeigten Beispiel keine Bestrahlung erforderlich ist, was zu einer stärkeren Kompaktierung des Substrats 25 an der Position B im Vergleich zur Position A führt.

Im gezeigten Beispiel folgt auf den Schritt des lokalen Kompaktierens keine homogene Temperung, vielmehr wird in einem in Fig. 2c dargestellten dritten Schritt eine lokale Temperung des Substrats 25 unter Verwendung eines nicht bildlich dargestellten Laserstrahls durchgeführt. Bei der lokalen Temperung wird an der Position B eine höhere Temperatur als Soll-Vorgabe vorgegeben als an der Position A. Dies führt dazu, dass die reflektierende Beschichtung 26 an der Position B stärker kompaktiert wird als an der Position A. Gleichzeitig geht die im zweiten Schritt in das Substrat 25 eingebrachte Kompaktierung an Position B stärker zurück, d.h. das Substrat 25 wird an der Position B stärker dekompaktiert als an der Position A. Im Ergebnis wird die Passe bzw. die Oberflächenform P_{B} des Substrats 25 an der Position B geglättet und gleichzeitig wird der Fehler in der Dicke der reflektierenden Beschichtung 26 behoben, sodass die Reflektivität R_{B} an der Position B mit der Soll-Reflektivität übereinstimmt. Der Spiegel Mi weist daher nach der Durchführung des zweiten und dritten Schritts an der Position B die Soll-Oberflächenform und die Soll-Reflektivität auf.

Bei der in Fig. 2a-c beschriebenen Herstellung des Spiegels Mi werden das lokale Kompaktieren des Substrats 25 und das lokale Kompaktieren der Beschichtung 26 gemeinsam optimiert. Generell werden für eine solche globale Optimierung des Herstellungsprozesses des Spiegels Mi folgende Einflussfaktoren berücksichtigt: eine lokale Oberflächenform P_{A}, P_{B}, ... bei der Herstellung Spiegels, eine Veränderung der lokalen Oberflächenform P_{A}, P_{B}, ... durch Dekompaktieren des Substrats 25 über die Lebensdauer des Spiegels Mi, eine lokale Reflektivität R_{A}, R_{B}, ... bei der Herstellung des Spiegels Mi, eine Veränderung der lokalen Reflektivität R_{A}, R_{B}, ... durch Kompaktierung der Beschichtung 26 über die Lebensdauer des Spiegels Mi, sowie eine zu erwartende Temperaturverteilung an der Oberfläche 25a des Substrats 25 beim Betrieb des Spiegels Mi in der Projektionsbelichtungsanlage 1 von Fig. 1.

Für die globale Optimierung werden bei der Herstellung des Spiegels Mi die lokale Oberflächenform P_{A}, P_{B}, ... des Spiegels Mi und die lokale Reflektivität R_{A}, R_{B}, ... des Spiegels Mi gemessen. Mit der lokalen Oberflächenform P_{A}, P_{B}, ... sowie mit der lokalen Reflektivität R_{A}, R_{B}, ... steht die volle Information über die lokalen Eigenschaften des Spiegels Mi zur Verfügung, die zum Erstellen des in Zusammenhang mit Fig. 2a-c beschriebenen hybriden Bearbeitungs- bzw. Herstellungsprozesses benötigt wird. Zusätzlich wird beim lokalen Tempern des Spiegels Mi die ortsabhängige Temperaturverteilung T an der Oberfläche 25a des Spiegels 25 gemessen, die in Fig. 3a an und in der Umgebung der Position B dargestellt ist. Wie in Fig. 3a zu erkennen ist, ist an der Position B die lokale Temperatur um einen Wert ΔT (in der Größenordnung von mehreren K) größer als in der Umgebung, um die weiter oben beschriebenen Fehler zu korrigieren. In Fig. 3b ist die Kompaktierung K_{S} des Substrats 25 dargestellt, die an der Position B durch das lokale Tempern inhomogen reduziert ist, z.B. um einen Wert ΔK_{S} von mehreren zehn Pikometern.

Fig. 3c zeigt die Kompaktierung K_{B} der reflektierenden Beschichtung 26 an der Position B, die gegenüber der Umgebung der Position B um einen Wert ΔK_{B} von bis zu mehreren hundert Pikometern abweicht. Die Kompaktierung K_{B} der reflektierenden Beschichtung 26 wurde anhand der ortsaufgelöst gemessenen Reflektivität R_{B} im Bereich der Position B bestimmt. Fig. 3d zeigt die Oberflächenform bzw. die Passe P des Spiegels Mi im Bereich der Position B, die sich aus der ortsaufgelöst durch Interferometrie gemessenen Oberflächenform P₃ im Bereich der Position B ergibt, wobei die Abweichung ΔP von der Oberflächenform in der Umgebung der Position B im Bereich von etwa hundert Pikometern liegt und der Summe aus der in Fig. 3b gezeigten Kompaktierung K_{S} des Substrats 25 und der in Fig. 3c gezeigten Kompaktierung K_{B} der reflektierenden Beschichtung 26 an der Position B entspricht. Die in Fig. 3b gezeigte Kompaktierung K_{S} des Substrats 25 kann anhand der in Fig. 3d gezeigten ortsaufgelöst gemessenen Oberflächenform P_{B} und anhand der in Fig. 3c gezeigten Kompaktierung K_{B} der reflektierenden Beschichtung 26 berechnet werden.

Fig. 4a zeigt den Spiegel Mi nach dem Abschluss des Herstellungsprozesses und entspricht der Darstellung von Fig. 2c. Fig. 4b zeigt den Spiegel Mi nach dem Betrieb in der in Fig. 1 gezeigten Projektionsbelichtungsanlage 1 am Ende seiner Lebensdauer. Wie in Fig. 4b zu erkennen ist, ist das Substrat 25 des Spiegels Mi am Ende seiner Lebensdauer an der Position A stärker dekompaktiert als an der Position B, d.h. der Unterschied zwischen der Passe P_{A} zum Zeitpunkt der Herstellung und der Passe P_{A,F} zum Ende der Lebensdauer ist an Position A größer als der Unterschied zwischen der Passe P_{B} zum Zeitpunkt der Herstellung und der Passe P_{B,F} zum Ende der Lebensdauer an der Position B.

Über die Lebensdauer des Spiegels Mi wurde zudem die reflektierende Beschichtung 26 an der Position A im Vergleich zur Position B stärker kompaktiert, d.h. die Differenz zwischen der Reflektivität R_{A} zum Zeitpunkt der Herstellung des Spiegels Mi und der Reflektivität R_{A,F} am Ende der Lebensdauer des Spiegels Mi an Position A ist größer als die Differenz zwischen der Reflektivität R_{B} an der Position B zum Zeitpunkt der Herstellung des Spiegels Mi und der Reflektivität R_{B,F} am Ende der Lebensdauer des Spiegels Mi.

Die geringere Veränderung der Kompaktierung K_{S} an der Position B über die Lebensdauer des Spiegels Mi ist darauf zurückzuführen, dass an der Position B die lokale Temperung mit einer höheren lokalen Temperatur erfolgte als an der Position A. Entsprechend ist das Substrat 25 bei der Herstellung an der Position A stärker dekompaktiert worden als an der Position B, weshalb die Dekompaktierung des Substrats 25 über die Lebensdauer an der Position B geringer ausfällt als an der Position A. Die geringere Veränderung der Reflektivität R_{B} an der Position B ist darauf zurückzuführen, dass die reflektierende Beschichtung 26 beim lokalen Tempern an der Position B stärker kompaktiert wurde als an der Position A. Entsprechend ist die Kompaktierung der reflektierenden Beschichtung 26 über die Lebensdauer des Spiegels Mi an der Position B geringer als an der Position A.

Die weiter oben beschriebenen Effekte der Veränderung der lokalen Oberflächenform P_{A}, P_{B}, ... sowie der lokalen Reflektivität R_{A}, R_{B} an unterschiedlichen Positionen A, B, ... über die Lebensdauer des Substrats 25 stellen Einflussfaktoren dar, die bei der globalen Optimierung des Herstellungsprozesses des Spiegels Mi berücksichtigt werden. Hierbei kann ausgenutzt werden, dass die physikalischen Gesetzmäßigkeiten bei der Dekompaktierung des Substrats 25 und der Kompaktierung der reflektierenden Beschichtung 26 während des Betriebs der Projektionsbelichtungsanlage 1 bekannt sind, da es sich um abklingende Funktionen mit den Parametern Zeit und Temperatur handelt.

Da die Veränderung der lokalen Oberflächenform P_{A}, P_{B}, ... sowie der lokalen Reflektivität R_{A}, R_{B} über die Lebensdauer des Spiegels Mi auch von der Temperatur im Betrieb des Spiegels Mi in der Projektionsbelichtungsanlage 1 abhängig ist, wird bei der Optimierung die zu erwartende Temperaturverteilung an der Oberfläche 25a des Substrats 25 berücksichtigt, und zwar typischerweise dadurch, dass das lokale Tempern an Positionen B der Oberfläche 25a des Substrats 25, an denen beim Betrieb des Spiegels Mi eine höhere Temperatur zu erwarten ist, mit einer höheren Temperatur erfolgt als an Positionen A, an denen beim Betrieb des Spiegels Mi eine geringere Temperatur zu erwarten ist. Auch auf diese Weise kann die Veränderung der lokalen Oberflächenform P_{A}, P_{B}, ... sowie der lokalen Reflektivität R_{A}, R_{B}, ... über die Lebensdauer des Spiegels Mi verringert werden.

## Patentansprüche

1. Verfahren zum Herstellen eines Spiegels (Mi) für eine Anlage der Halbleiterlithographie, insbesondere für ein EUV-Lithographiesystem (1), umfassend:
Aufbringen einer reflektierenden Beschichtung (26) auf eine Oberfläche (25a) eines Substrats (25) des Spiegels (Mi),
Lokales Kompaktieren des Substrats (25), bevorzugt durch Elektronenstrahlbearbeiten, insbesondere mit nachfolgendem Tempern, insbesondere homogenem Tempern,
Lokales Kompaktieren der reflektierenden Beschichtung (26) durch lokales, bevorzugt strahlungsinduziertes Tempern des Spiegels (Mi),
**dadurch gekennzeichnet,**
**dass** das lokale Kompaktieren des Substrats (25) und das lokale Kompaktieren der reflektierenden Beschichtung (26) bei der Herstellung des Spiegels (Mi) gemeinsam optimiert werden, wobei folgende Einflussfaktoren berücksichtigt werden:
- eine lokale Oberflächenform (P_{A}, P_{B}) bei der Herstellung des Spiegels (Mi),
- eine Veränderung der lokalen Oberflächenform (P_{A}, P_{B}) durch Dekompaktieren des Substrats (25) über die Lebensdauer des Spiegels (Mi),
- eine lokale Reflektivität (R_{A}, R_{B}) des Spiegels (Mi),
- eine Veränderung der lokalen Reflektivität (R_{A}, R_{B}) durch Kompaktierung der reflektierenden Beschichtung (26) über die Lebensdauer des Spiegels (Mi), sowie
- eine zu erwartende Temperaturverteilung an der Oberfläche (25a) des Substrats (25) beim Betrieb des Spiegels (Mi) in der Anlage der Halbleiterlithographie.

2. Verfahren nach Anspruch 1, bei dem bei der Herstellung des Spiegels (Mi) die lokale Oberflächenform (P_{A}, P_{B}) des Spiegels (Mi) und die lokale Reflektivität (R_{A}, R_{B}) des Spiegels (Mi) gemessen werden.

3. Verfahren nach Anspruch 1 oder 2, bei dem beim lokalen Tempern des Spiegels (Mi) eine ortsabhängige Temperaturverteilung (T) an der Oberfläche (25a) des Substrats (25) gemessen wird.

4. Verfahren nach einem der vorhergehenden Ansprüche, bei dem beim gemeinsamen Optimieren an Positionen (B) an der Oberfläche (25a) des Substrats (25), an der das Substrat (25) lokal stärker kompaktiert wird, das lokale Tempern des Substrats (25) mit einer höheren Temperatur erfolgt als an Positionen (A) an der Oberfläche (25a) des Substrats (25), an denen das Substrat (25) lokal weniger stark kompaktiert wird.

5. Verfahren nach einem der vorhergehenden Ansprüche, bei dem beim gemeinsamen Optimieren an Positionen (B) der Oberfläche (25a) des Substrats (25), an denen die reflektierende Beschichtung (26) lokal stärker kompaktiert wird, das lokale Tempern des Substrats (25) mit einer höheren Temperatur erfolgt als an Positionen (A) an der Oberfläche (25a) des Substrats (25), an denen die reflektierende Beschichtung (26) lokal weniger stark kompaktiert wird.

6. Verfahren nach einem der vorhergehenden Ansprüche, bei dem die zu erwartende Temperaturverteilung an der Oberfläche (25a) des Substrats (25) beim Betrieb des Spiegels (Mi) in der Anlage der Halbleiterlithographie bei der Optimierung berücksichtigt wird, indem das lokale Tempern an Positionen (B) der Oberfläche (25a) des Substrats (25), an denen beim Betrieb des Spiegels (Mi) eine höhere Temperatur zu erwarten ist, mit einer höheren Temperatur erfolgt als an Positionen (A), an denen beim Betrieb des Spiegels (Mi) eine geringere Temperatur zu erwarten ist.

7. Verfahren nach einem der vorangegangenen Ansprüche, beim welchem das lokale Kompaktieren des Substrats (25) und das lokale Kompaktieren der reflektierenden Beschichtung (26) bei der Herstellung des Spiegels (Mi) unter Zuhilfenahme einer Methode des maschinellen Lernens gemeinsam optimiert werden.
